# EUROPÄISCHE PATENTSCHRIFT

(11) **EP 1 454 392 B1**
(45) Veröffentlichungstag und Bekanntmachung des Hinweises auf die Patenterteilung: **29.03.2006**
(21) Anmeldenummer: 02792737.5
(22) Anmeldetag: 06.11.2002
(51) Int. Cl.: H01S 5/14

(54) **VERFAHREN UND VORRICHTUNG ZUR ERZEUGUNG VON LASERSTRAHLUNG AUF BASIS VON HALBLEITERN**
METHOD AND DEVICE FOR PRODUCING LASER RADIATION BASED ON SEMICONDUCTORS
PROCEDE ET DISPOSITIF DE PRODUCTION DE RAYONNEMENT LASER SUR LA BASE DE SEMI-CONDUCTEURS

(30) Priorität: 12.12.2001 DE 10161076
(43) Veröffentlichungstag der Anmeldung: 08.09.2004
(73) Patentinhaber: Universität Potsdam, 14469 Potsdam (DE)
(72) Erfinder: RAAB, Volker, 14469 Potsdam (DE); MENZEL, Ralf, 10719 Berlin (DE)
(74) Vertreter: Hengelhaupt, Jürgen
(86) Internationale Anmeldenummer: PCT/EP2002/012400
(87) Internationale Veröffentlichungsnummer: WO 2003/055018

(56) Entgegenhaltungen:
- US-A- 4 785 462
- US-A- 5 696 779
- PATENT ABSTRACTS OF JAPAN vol. 010, no. 054 (E-385), 4. März 1986 (1986-03-04) & JP 60 207389 A (KOGYO GIJUTSUIN;OTHERS: 0J), 18. Oktober 1985 (1985-10-18)
- PATENT ABSTRACTS OF JAPAN vol. 2002, no. 02, 2. April 2002 (2002-04-02) & JP 2001 284718 A (SONY CORP), 12. Oktober 2001 (2001-10-12)
- PATENT ABSTRACTS OF JAPAN vol. 007, no. 166 (E-188), 21. Juli 1983 (1983-07-21) & JP 58 071687 A (RICOH KK), 28. April 1983 (1983-04-28)
- PATENT ABSTRACTS OF JAPAN vol. 1995, no. 06, 31. Juli 1995 (1995-07-31) & JP 07 079040 A (ISHIKAWAJIMA HARIMA HEAVY IND CO LTD), 20. März 1995 (1995-03-20)

## Beschreibung

Die Erfindung betrifft ein Verfahren und eine Vorrichtung zur Erzeugung von Laserstrahlung auf Basis von Halbleitern.

Halbleiterlaser werden wegen ihrer geringen Gerätedimensionen und ihres hohen Wirkungsgrades bereits in der Augenheilkunde, im Bereich der Biostimulation, der Phototherapie und weiteren Gebieten eingesetzt. Auch für den Bereich der Mikrochirurgie, das Pumpen von Faserlasern für Lichtquellen im sichtbaren Spektralbereich, direkte Frequenzkonversion in den blauen Spektralbereich, Kunststoffschweißung, Markierungs- und Beschriftungsanwendungen, das Pumpen von Mikrochiplasern und Spektroskopie kommen Halbleiterlaser in Betracht. Für solche Anwendungen sind eine hohe Ausgangsleistung und eine hohe Strahlqualität erforderlich.

Beim Halbleiterlaser wird die für den Laserbetrieb notwendige Besetzungsinversion zwischen dem Leitungsband und dem Valenzband erzeugt. Elektronen, die durch den Pumpprozess aus dem Valenzband ins Leitungsband gehoben werden, erzeugen nach Ablauf ihrer natürlichen Lebensdauer durch spontane Emission die so genannte Rekombinationsstrahlung. Durch stimulierte Emissionen in einem optischen Resonator wird kohärente Laserstrahlung erzeugt.

Eine Inversion in einem Halbleiterlaser kann durch optisches Pumpen, durch Beschuss mit hoch energetischen Elektronen und durch Injektion von Minioritätsträgern in einem pn-Übergang (Diodenlaser) erreicht werden. Beim Diodenlaser, der die größte technische Bedeutung unter den Halbleiterlasern besitzt, werden zwei unterschiedlich dotierte Halbleiter zu einer pn-Diode aneinander gefügt und bilden an der Käntaktstelle eine so genannte Sperrschicht aus, die nach einer kurzen Relaxationszeit keine weitere Rekombination von Elektronen und Löchern zulässt. Durch das Anlegen einer äußeren Spannung wird ein Diodenstrom aufrechterhalten, der ständig Elektronen und Löcher in die Sperrschicht injiziert. Die Elektronen rekombinieren mit den Löchern und geben dabei Strahlung ab. Diese Rekombinationsstrahlung ist daher eine direkte Folge des Injektionsstromes.

Die beschriebenen Vorgänge treten in gleicher Weise auch bei gewöhnlichen Halbleiterdioden und Leuchtdioden auf. Der wesentliche Unterschied bei Laserdioden besteht darin, dass zum Einen durch die gezielte Wahl der Halbleitermaterialien und der Dotierungskonzentrationen die Zahl der strahlungslosen Übergänge minimiert und die Zahl der strahlenden Übergänge maximiert wird und dass zum Anderen die emittierte Strahlung in einem Resonator verstärkt wird. Der Resonator wird in der Regel durch planparallele Endflächen hoher optischer Güte eines Kristalls gebildet.

Diodenlaser besitzen allerdings auch Eigenschaften, die für die Spektroskopie ungünstig sind, nämlich geringe spektrale Reinheit, ein unsauberes Strahlprofil und keine kontinuierliche Verstimmbarkeit. Dennoch werden Diodenlaser vielfältig in spektroskopischen Anwendungen eingesetzt, denn mit geeigneten optischen und elektrischen Kontrollmechanismen lassen sich die Frequenz, Strahl- und Verstimmungseigenschaften erheblich verbessern. Grund für die schlechte Strahlqualität ist, dass sich bei Halbleiterlasern im optischen Resonator Transversalmoden unterschiedlicher Ordnungen ausbilden. Sie sind für die erreichbare Strahlqualität von größter Bedeutung und Folge von Beugungs- und Interdifferenzphänomenen, und spiegeln die räumliche Verteilung der Schwingungsenergie im Laserresonator wieder.

Es sind unterschiedliche Verfahren und Vorrichtungen zur Strahlqualitätsverbesserung bei Diodenlasern, insbesondere bei Hochleistungsdiodenlasern in Breitstreifengeometrie, bekannt. Beispielsweise werden mittels externer Resonatoren eine oder wenige Transversalmoden selektiert, um möglichst viele andere Transversalmoden unterdrücken zu können, um hierdurch die Strahlqualität zu verbessern. Alle hierfür bekannten Resonatoranordnungen besitzen mehrere, zum Teil komplizierte und teure optische Komponenten.
Nachteilig sind somit die hohen Materialkosten und der erhöhte Montageaufwand. Weiterhin besitzen diese Vorrichtungen eine hohe Anfälligkeit gegen eine mögliche Dejustierung.
Es ist weiterhin bekannt, zur Verbesserung der Strahlqualität die Breitstreifenlaser durch Seedlaser und/oder Trapezverstärker zu ersetzen. Nachteilig an diesen Vorrichtungen ist ebenfalls ein hoher Material- und Montageaufwand. Weiterhin ist es bekannt, externe Resonatoren aus Linsen, Etalons und/oder phasenkonjugierenden Spiegeln zu verwenden. Diese sind entweder nicht stabil bei hohen Pumpströmen oder in der Fertigung sehr aufwendig und daher kostenintensiv.

Es ist daher Aufgabe der vorliegenden Erfindung, eine Vorrichtung zur Erzeugung von Laserstrahlung auf Basis von Halbleitern anzugeben, mit welcher Laserlicht von hoher Strahlqualität erzeugt werden kann, wobei die Vorrichtung kostengünstiger herstellbar und gegen Dejustagen unanfälliger als die bekannten Vorrichtungen sein soll. Es soll weiterhin ein Verfahren zur Erzeugung von Laserstrahlung auf Basis von Halbleitern angegeben werden, welches die genannten Nachteile der bekannten Verfahren nach dem Stand der Technik eliminiert.

Diese Aufgabe wird erfindungsgemäß gelöst durch die Merkmale im kennzeichnenden Teil des Anspruchs 1 (Verfahrensanspruch) und die Merkmale im kennzeichnenden Teil des Anspruchs 6 (Vorrichtungsanspruch) im Zusammenwirken mit den Merkmalen im Oberbegriff. Zweckmäßige Ausgestaltungen der Erfindung sind in den Unteransprüchen enthalten.

Ein besonderer Vorteil der Erfindung besteht darin, dass mit der erfindungsgemäßen Vorrichtung bzw. dem erfindungsgemäßen Verfahren eine hohe Strahlqualität des aus dem Halbleiterlaser austretenden Lichts bei einer minimalen Anzahl optischer Komponenten erreicht werden kann. Dazu weist die erfindungsgemäße Vorrichtung einen Halbleiter mit einem außerhalb des Halbleiters angeordneten, reflektierenden Element zur Ausbildung eines externen, instabilen Resonators auf. Dabei ist es nicht notwendig, dass das reflektierende Element einen Einfluss auf die Divergenz des aus dem Halbleiterchip austretenden Lichts hat. Das reflektierende Element ist in einem solchen Abstand vom Halbleiterchip angeordnet, dass die Anordnung einen externen, instabilen Resonator ausbildet und darüber hinaus das aus dem Halbleiterchip austretende divergente Licht teilweise zum Halbleiter zurück reflektiert und in diesen eingekoppelt wird. Die Ausbildung eines externen, instabilen Resonators bedeutet dabei nicht, dass es gar keine fokussierenden Elemente gibt, sondern nur, dass diese nicht ausreichen, um den Resonator stabil zu machen.

Vorzugsweise übersteigt die Breite (FHWM) des durch den externen Resonator rückkoppelnden Lichts, welche als volle Breite bei halber Intensität gemessen wird, die Breite (FHWM) der Eintritts-/Austrittsöffnung des Halbleiterlasers um mindestens das Dreifache.

Der Halbleiterlaser kann vorzugsweise ein kantenemittierender Hochleistungs-Diodenlaser oder ein Vertikalemitter (VCSL) sein. Die erfindungsgemäße Vorrichtung kann zusätzlich eine Zylinderlinse zur Reduktion der Lichtdivergenz aufweisen.

Bei einem kantenemittierenden Hochleistungs-Diodenlaser kann die erfindungsgemäße Vorrichtung zusätzlich eine Zylinderlinse zur Reduktion der hohen Lichtdivergenz aufweisen.

Das reflektierende Element ist vorzugsweise ein Planspiegel. Es ist aber auch möglich, dass das reflektierende Element ein gekrümmter Spiegel ist. Die Flächennormale des Planspiegels kann einen endlichen Winkel zur Flächennormalen des Halbleiterchips aufweisen. Dieser Winkel kann einen solchen Wert annehmen, welcher durch Transversalmoden höherer Ordnung des Halbleiterlasers bestimmt bzw. durch die Elektrodenkontaktierung des Halbleiterlasers präferiert ist.

Der Abstand d zwischen Planspiegel und Halbleiterchip sollte die Bedingung 0.1 < d * λ / D² < 10 erfüllen, wobei D die Breite der Austrittsöffnung des Halbleiterchips und λ die Emissionwellenlänge ist. Vorzugsweise weist die Eintritts-/Austrittsöffnung des Halbleiterchips eine Ausdehnung zwischen 100 µm und 1 mm auf und der Abstand d zwischen Halbleiterchip und Planspiegel beträgt zwischen 3 cm und 10 cm.

Die erfindungsgemäße Vorrichtung kann zusätzlich eine Blende zur Selektion bevorzugter Beugungsmaxima aufweisen.

Zur Frequenzstabilisierung kann das reflektierende Element ein frequenzselektives Element, wie z.B. ein Gitter sein. Weiterhin kann die erfindungsgemäße Vorrichtung weitere frequenzselektive Elemente, wie z.B. ein Etalon, aufweisen.

In einer bevorzugten Ausführungsform weist der Halbleiterchip ein moduliertes Gainprofil und/oder ein Brechungsindexprofil auf. Dieses kann wahlweise durch eine geschickt gewählte Elektrodenkontaktierung, durch zusätzliche Layer in der Epitaxie, durch Ätzprozesse, oder durch Dickenmodulation einzelner Schichten erzeugt werden. In einer besonders bevorzugten Ausführungsform weist der Halbleiter eindiffundierte niederohmige Kontaktstreifen in einem ansonsten hochohmigen Halbleitermaterial auf. Der Sinus des optimalen Winkels für Laserbetrieb ergibt sich dann als Verhältnis aus halber Wellenlänge und Modulationsperiode oder Vielfache dieses Verhältnisses.

Beim erfindungsgemäßen Verfahren zur Erzeugung von Laserstrahlung auf Basis von Halbleitern durch stimulierte Emission in einem Halbleiterlaser wird ein Teil des aus dem Halbleiter austretenden Laserlichts in diesen Halbleiter zurück reflektiert und wiederum ein Teil dieses reflektierten Laserlichts über die Eintritts-/Austrittsöffnung des Halbleiterchips in diesen eingekoppelt, wobei die stimulierte Emission über einen externen, instabilen Resonator bewirkt wird. Vorzugsweise wird die Reflexion eines Teils des aus dem Halbleiter austretenden Laserlichts durch einen Planspiegel bewirkt.
Darüber hinaus kann mindestens ein Beugungsmaximum, außer dem zentralen Beugungsmaximum, vignettiert, d.h. ausgeblendet werden.
Durch die geringe Anzahl an Elementen können die Materialkosten und der Justageaufwand minimiert werden. Ferner sind die Möglichkeiten von Dejustagen im laufenden Betrieb minimal. Weiterhin vorteilhaft ist, dass die erfindungsgemäße Anordnung sehr kompakt aufgebaut werden kann. Durch diese kompakte Bauform werden die Einsatzbereiche erweitert. Das Fehlen diverser Komponenten eliminiert gleichzeitig Fehlerquellen der Modenselektion, die durch nichtperfekte Funktion der Elemente hervorgerufen werden und sich negativ auf die Strahlqualität auswirken können.

Die Reflexion eines Teils des aus dem Halbleiterchip austretenden Laserlichts kann durch einen Planspiegel bewirkt werden. Die Flächennormale des Planspiegels kann einen endlichen Winkel zur Flächennormalen des Halbleiterchips aufweisen. Das zentrale Beugungsmaximum des reflektierten Lichts kann durch eine zusätzliche, resonatorexterne Apertur selektiert werden.

Erfindungsgemäß kann ein Halbleiterlaser mit einem externen, instabilen Resonator zur Verbesserung der Strahlqualität des emittierten Laserlichts verwendet werden. Ein Halbleiterlaser mit einem externen, instabilen Resonator kann erfindungsgemäß darüber hinaus zur Beeinflussung spektraler Eigenschaften des emittierten Laserlichts verwendet werden.

Die Erfindung soll nachstehend anhand von zumindest teilweise in den Figuren dargestellten Ausführungsbeispielen näher erläutert werden.
Es zeigen:
- Fig. 1:: eine schematische Darstellung einer erfindungsgemäßen Vorrichtung zum Betrieb eines kantenemittierenden Breitstreifenlasers längs seiner optischen Achse (on-axis),
- Fig. 2:: eine schematische Darstellung einer erfindungsgemäßen Vorrichtung eines kantenemittierenden Breitstreifenlasers mit Emission außerhalb seiner optischen Achse (off-axis),
- Fig. 3:: eine schematische Darstellung einer erfindungsgemäßen Vorrichtung eines kantenemittierenden Breitstreifenlasers mit Emission außerhalb seiner optischen Achse (off-axis) mit einem Gitter als reflektierendes Element und einem Etalon zur Frequenzstabilisierung,
- Fig. 4:: eine schematische Darstellung eines Halbleiterlasers mit einem Gainprofil mit eindiffundierten niederohmigen Kontaktstreifen in einem hochohmigen Halbleitermaterial.

Der Erfindung liegt die Idee zugrunde, ein Gainmedium mit einem externen, instabilen Resonator zu kombinieren. Instabile Laserresonatoren, die nach herkömmlichen Lasertheorie keine stabilen Lasermode besitzen, können jedoch eine definierte und zeitlich unveränderliche Lasermode ausbilden, sofern die Verluste aufgrund hoher Verstärkung des aktiven Mediums ausgeglichen werden.
Eine Anwendung instabiler Laserresonatoren auf Halbleiter- laser ist aus US 4 426 707 A bekannt.
Überraschebderweise kann mit Halbleiterlasern eine gute Strahlqualität bei hohen Leistungen erzielt werden, sofern der Halbleiterchip außer mit einer Zylinderlinse nur noch mit einem einzigen Planspiegel für die Rückkopplung kombiniert wird, wobei der Spiegel spezielle Anforderungen an Winkel und Abstand zu erfüllen hat. Grundsätzlich ist zu erwarten, dass eine solche Rückkopplung mittels eines instabilen Laserresonators zu hohe Verluste besitzt, um zu einem Laserbetrieb zu gelangen. Dies ist jedoch vor allem bei Hochleistungsdiodenlasern nicht der Fall, da die hohen Leistungsverluste tolerierbar sind. Somit kann auf weitere Elemente, wie Linsen, Gitterspiegel und Phasenkonjugatoren völlig verzichtet werden.
Der Abstand d zwischen einem Halbleiterchip und dem Planspiegel muss einerseits gering genug sein, um die Verluste tolerieren zu können, andererseits muss dieser Abstand groß genug sein, damit sich die Wellenfront des frei propagierenden Lichts zu einer ebenen Welle annähert. Diese Annäherung gilt um so besser, je größer der Abstand zwischen Halbleiterchip und Spiegel ist. Die vom Spiegel reflektierte Welle wird vom Halbleiterchip, der als Apertur wirkt, abgeschnitten und verstärkt.

Für einen optimalen Betrieb muss der Abstand zwischen Chip und Spiegel gefunden werden, um einerseits die Verluste gering zu halten und andererseits eine möglichst hohe Strahlqualität zu erreichen. Dieser Bereich hängt von der Chipgeometrie, den Verstärkungseigenschaften, der Wellenlänge, der Güte des Spiegels, der selektierten transversalen Mode sowie gegebenenfalls vom Vorhandensein weiterer optischer Elemente, die Einfluss auf die Divergenz- oder Intensitätsverteilung nehmen, ab.

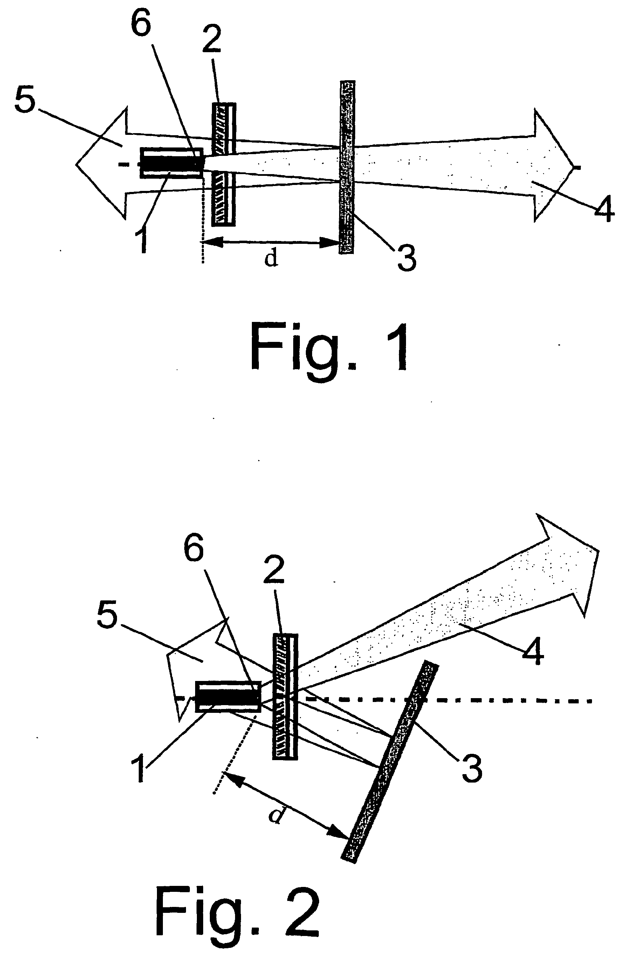

Fig. 1 zeigt eine schematische Darstellung einer erfindungsgemäßen Vorrichtung zur Erzeugung von Laserlicht hoher Strahlqualität mit einem Halbleiterchip 1. Das aus dem Halbleiterchip 1 emittierte Licht eines kantenemittierenden Breitstreifenlasers trifft auf einen teildurchlässigen Planspiegel 3. Ein Teil des Lichts tritt durch diesen teildurchlässigen Planspiegel 3 hindurch und kann als Auskoppellicht 4 für Anwendungen bereitstehen. Das restliche, reflektierte Rückkoppellicht 5 läuft zum Halbleiterchip 1 zurück. Nur der Teil des Rückkoppellichts 5, der den verstärkenden Bereich des Halbleiterchips 1 trifft, kann zum Laserbetrieb beitragen. Dieser Bereich wird durch die Eintritts-/Austrittsöffnung 6 bestimmt. Dabei handelt es sich um den zentralen Bereich der Emission, dessen Intensitätsschwankungen sehr viel kleiner sind als die Intensität selbst. Die Wellenfront, also die lokale Ausbreitungsrichtung in der Nähe der Eintritts-/Austrittsöffnung 6, ist eine Kugeloberfläche. Diese Kugeloberfläche ist über die Breite des Emitters nur sehr geringfügig gekrümmt. Bei kantenemittierenden Laserdioden ist eine kurzbrennweitige Zylinderlinse 2 vorteilhaft, da sie die hohe Divergenz des Lichts in der Ebene senkrecht zur Epitaxie reduziert und dadurch die Effizienz der Rückkopplung erhöht. Ein entsprechender Aufbau für Vertikalemitter würde über die gleichen Komponenten verfügen, jedoch ist eine Zylinderlinse 2 aufgrund der Tatsache, dass die Laserdiode des Vertikalemitters durch ihre Oberfläche emittiert, unter Umständen entbehrlich.

Fig. 2 zeigt eine schematische Darstellung einer Vorrichtung zur Erzeugung hoher Strahlqualität mit einem kantenemittierenden Breitstreifenlaser, welcher nicht längs seiner optischen Achse emittiert (off-axis). Der Halbleiterchip 1 bekommt über den Planspiegel 3 einen Teil des von ihr emittierten Laserlichts zurück. Dieses Rückkoppellicht 5 wird verstärkt und verlässt den Halbleiterchip 1 gemäß der Reflexionsgesetze. Der Winkel ist dabei durch die Verbindungslinie zwischen Halbleiterchip 1 und Flächennormale des Planspiegels 3 definiert. Durch Verkippung eines der beiden Elemente lässt sich der Winkel einstellen. Die Aussagen zu Wellenfrontintensität und dem Betrieb von Vertikalemittern gelten hier genauso wie im Fall der on-axis-Emission.

Für den geforderten Abstand, der einerseits kurz genug sein muss, um die Verluste gering zu halten und andererseits lang genug sei muss, um eine hohe Strahlqualität zu erreichen, kann folgende Abschätzung vorgenommen werden: 0.1 < d * λ / D² < 10, wobei D die Breite der Einritts-/Austrittsöffnung 6 des Halbleiters, λ die Emissionswellenlänge und d der Abstand zwischen Halbleiterchip 1 und Planspiegel 3 ist.
Diese Abschätzung gilt für den Fall eines Planspiegels und keiner weiteren vorhandenen strahlformenden Elemente wie Linsen usw.

Anderenfalls sind die Längen bzw. Abstände gemäß der Abbildungsgesetze der Optik umzurechnen. Mit der erfindungsgemäßen Vorrichtung gemäß Fig. 1 bzw. Fig. 2 lassen sich für das resultierende Licht Beugungsmesszahlen von M²< 2 erreichen.
Eine weitere Verbesserung der Strahlqualität bis zu Werten nahe M² = 1 lässt sich erzielen, indem man vom resultierenden Licht, das nahezu dem einer homogen beleuchteten Rechteckblende entspricht, mittels einer resonatorexternen Blende lediglich das zentrale Beugungsmaximum passieren lässt.
Die resultierende Winkelverteilung entspricht derjenigen einer harten Schlitzblende. Ein resultierender Strahlpropagationsfaktor von etwa 2 stellt eine deutliche Verbesserung zu den Propagationsfaktoren typischer Breitstreifendiodenlaser von ca. 30 bis 60 dar.
Grundsätzlich lässt sich das oben beschriebene Verhalten dann beobachten, wenn die Breite der Lichtverteilung (FHWM) des rückkoppelnden Lichts bei Wiedereintritt in den verstärkenden Bereich breiter als der Verstärkungsbereich selbst ist.

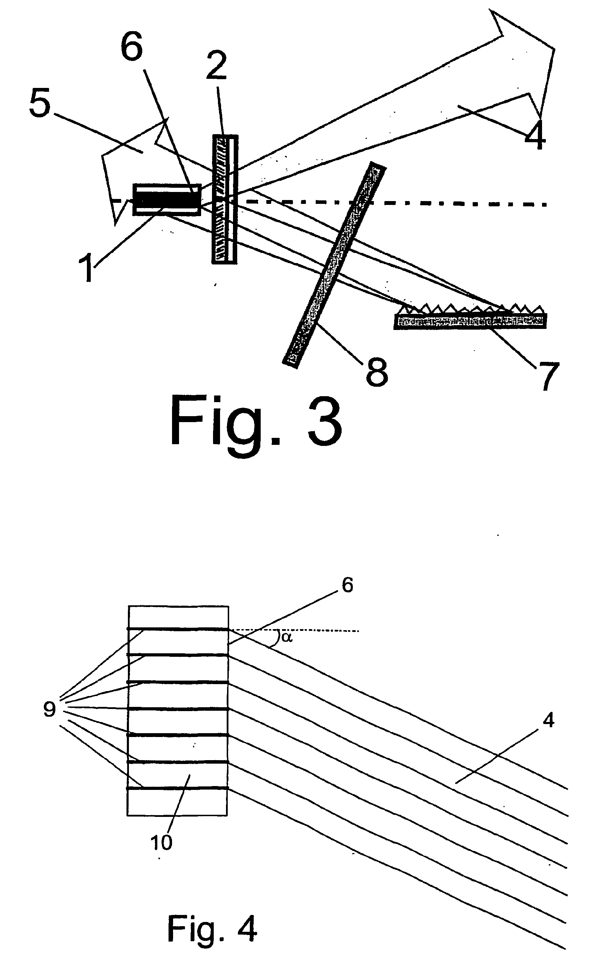

Fig. 3 zeigt eine schematische Darstellung einer Vorrichtung zur Erzeugung hoher Strahlqualität mit einem kantenemittierenden Breitstreifenlaser, welcher nicht längs seiner optischen Achse emittiert (off-axis), wobei das reflektierende Element ein Gitter 7 ist. Zusätzlich weist die Vorrichtung ein Etalon 8 zur Frequenzstabilisierung auf. Auch in dieser Anordnung bildet die erfindungsgemäße Vorrichtung einen instabilen Resonator aus. Grundsätzlich wäre zu erwarten, dass die Rückkoppelung bei den erfindungsgemäßen Vorrichtungen, wie in Fig. 1 bis Fig. 3 dargestellt, zu hohe Verluste besitzt, um zu Laserbetrieb zu gelangen. Überraschender Weise hat sich bei Verwendung eines Halbleiterlasers mit einem externen, instabilen Resonator der Effekt gezeigt, dass man Laserlicht hoher Strahlqualität erreicht, wobei die Realisierung nur wenige optische Komponenten erfordert.

In einem bevorzugten Ausführungsbeispiel weist der Halbleiterchip 1 ein moduliertes Gainprofil und/oder ein Brechungsindexprofil auf. Dieses kann wahlweise durch eine geschickt gewählte Elektrodenkontaktierung, durch zusätzliche Layer in der Epitaxie, durch Ätzprozesse, oder durch Dickenmodulation einzelner Schichten erzeugt werden. Es hat sich gezeigt, dass mit einem solchen Halbleiter ein besonders effizienter Laserbetrieb mit einem externen, instabilen Resonator erreicht werden kann. In einer besonders bevorzugten Ausführungsform weist der Halbleiter 20 eindiffundierte niederohmige Kontaktstreifen 9 in einem ansonsten hochohmigen Halbleitermaterial auf, wie in Fig. 4 dargestellt ist. Der Sinus des optimalen Winkels für Laserbetrieb ergibt sich dann als Verhältnis aus halber Wellenlänge und Modulationsperiode oder Vielfache dieses Verhältnisses.

Die Erfindung ist nicht beschränkt auf das hier dargestellte Ausführungsbeispiel. Vielmehr ist es möglich, durch Kombination und Modifikation der genannten Mittel und Merkmale weitere Ausführungsvarianten zu realisieren, ohne den Rahmen der Erfindung zu verlassen.

### Bezugszeichenliste

- 1: Halbleiter/Halbleiterchip
- 2: Zylinderlinse
- 3: Reflektierendes Element/ Planspiegel
- 4: Auskoppellicht
- 5: Rückkoppellicht
- 6: Eintritts-/Austrittsöffnung
- 7: Gitter
- 8: Etalon
- 9: Kontaktstreifen
- 10: Halbleiter

## Patentansprüche

1. Verfahren zur Erzeugung von Laserstrahlung auf Basis von Halbleitern durch stimulierte Emission in einem Halbleiter (1), wobei ein Teil des aus dem Halbleiter (1) austretenden, divergenten Laserlichts mittels eines reflektierenden Elements (3) zum Halbleiter (1) zurück reflektiert wird, und ein Teil dieses reflektierten Laserlichts über die Eintritts-/Austrittsöffnung (6) des Halbleiters (1) in diesen wieder eingekoppelt wird, wobei die stimulierte Emission in dem Halbleiter (1) über einen externen instabilen Resonator bewirkt wird,
**dadurch gekennzeichnet,**
**dass** der Abstand d zwischen dem Halbleiter (1) und reflektierendem Element (3), für einen Planspiegel ohne Verwendung weiterer strahlformender Elemente der Bedingung 0.1 < d * λ / D² < 10 genügt, wobei D die Breite der Eintritts-/Austrittsöffnung (6) des Halbleiters (1) und λ, die Emissionwellenlänge ist und die Bedingung bei Verwendung weiterer strahlformender Elemente und/oder eines anderen reflektierenden Elements (3) durch Umrechnung von Längen und Abständen gemäß den Abbilddungsgesetzen der Optik rechnerisch angepaßt wird.

2. Verfahren nach Anspruch 1,
**dadurch gekennzeichnet,**
**dass** auf die Divergenz des aus dem Halbleiter (1) austretenden, divergenten Laserlichts in der Ebene der Epitaxie kein Einfluss genommen wird.

3. Verfahren nach einem der vorhergehenden Ansprüche,
**dadurch gekennzeichnet,**
**dass** die Reflexion eines Teils des aus dem Halbleiter (1) austretenden Laserlichts durch einen Planspiegel (3) oder einen gekrümmten Spiegel bewirkt wird.

4. Verfahren nach einem der vorhergehenden Ansprüche,
**dadurch gekennzeichnet,**
**dass** die Flächennormale des reflektierenden Elements (3) einen endlichen Winkel zur Flächennormalen der Lichtaustrittsfacette des Halbleiters (1) aufweist.

5. Verfahren nach einem der vorhergehenden Ansprüche,
**dadurch gekennzeichnet,**
**dass** durch eine resonatorexternen Apertur mindestens ein Beugungsmaximum, außer dem zentralen Beugungsmaximum, vignettiert oder ausgeblendet wird.

6. Vorrichtung zur Erzeugung von Laserstrahlung bestehend aus einem externen, instabilen Resonator, welcher einen Halbleiter (1) und ein außerhalb des Halbleiters (1) angeordnetes reflektierendes Element (3) aufweist,
**dadurch gekennzeichnet, dass**
der Abstand d zwischen dem Halbleiter (1) und reflektierendem Element (3) für einen Planspiegel ohne Verwendung weiterer strahlformender Elemente so gewählt ist, dass er der Bedingung 0.1 < d * λ / D² < 10 genügt, wobei D die Breite der Eintritts-/Austrittsöffnung (6) des Halbleiters (1) und λ die Emissionwellenlänge ist und die Bedingung bei Verwendung weiterer strahlformender Elemente und/oder eines anderen reflektierenden Elements (3) durch Umrechnung von Längen und Abständen gemäß den Abbildungsgesetzen der Optik rechnerisch angepaßt ist.

7. Vorrichtung nach Anspruch 6,
**dadurch gekennzeichnet,**
**dass** die Breite (FHWM) des durch den externen Resonator rückkoppelnden Lichts, welche als volle Breite bei halber Intensität gemessen wird, die Breite (FHWM) der Eintritts-/Austrittsöffnung (6) um mindestens das dreifache des Halbleiters (1) übersteigt.

8. Vorrichtung nach Anspruch 6 oder 7,
**dadurch gekennzeichnet,**
**dass** der Halbleiterlaser ein kantenemittierender Hochleistungs-Diodenlaser oder ein Vertikalemitter (VCSL) ist.

9. Vorrichtung nach Anspruch 8,
**dadurch gekennzeichnet,**
**dass** die Vorrichtung zusätzlich eine Zylinderlinse (2) aufweist, welche zwischen reflektierendem Element (3) und Halbleiter (1) derart angeordnet ist, dass sie auf die Divergenz des Laserlicht in der Ebene der Epitaxie keinen Einfluss nimmt.

10. Vorrichtung nach Anspruch 6 bis 9,
**dadurch gekennzeichnet,**
**dass** das reflektierende Element (3) ein Planspiegel oder ein gekrümmter Spiegel ist.

11. Vorrichtung nach Anspruch 10,
**dadurch gekennzeichnet,**
**dass** die Flächennormale des Planspiegels (3) einen endlichen Winkel zur Flächennormalen der Lichtaiistrittsfacette des Halbleiters (1) aufweist.

12. Vorrichtung nach Anspruch 11,
**dadurch gekennzeichnet,**
**dass** der Winkel der Flächennormalen einen Wert annimmt, durch welchen Transversalmoden höherer Ordnung des Halbleiterlasers bestimmt sind.

13. Vorrichtung nach Anspruch 12,
**dadurch gekennzeichnet,**
**dass** der Winkel der Flächennormalen einen Wert annimmt, welcher derjenigen Transversalmode entspricht, die durch die Elektrodenkontaktierung des Halbleiterlasers präferiert ist.

14. Vorrichtung nach Anspruch 10 bis 13 ,
**dadurch gekennzeichnet,**
**dass** die Eintritts-/Austrittsöffnung (6) des Halbleiters (1) eine Ausdehnung von, 100 µm bis 1 mm aufweist und der Abstand zwischen Halbleiter (1) und Planspiegel (3) zwischen 3 cm und 10 cm beträgt.

15. Vorrichtung nach Anspruch 6 bis 14,
**dadurch gekennzeichnet,**
**dass** die Vorrichtung eine zusätzliche Apertur aufweist.

16. Vorrichtung nach Anspruch 15,
**dadurch gekennzeichnet,**
**dass** die Apertur eine Blende ist.

17. Vorrichtung nach Anspruch 6 bis 16,
**dadurch gekennzeichnet,**
**dass** das reflektierende Element (3) mindestens ein frequenzselektives Element ist.

18. Vorrichtung nach Anspruch 17,
**dadurch gekennzeichnet,**
**dass** das frequenzselektive Element ein Gitter (7) oder ein Etalon (8) ist.

19. Vorrichtung nach Anspruch 6 bis 18,
**dadurch gekennzeichnet,**
**dass** der Halbleiter (1) ein Gainprofil und/oder ein Brechungsindexprofil aufweist.

20. Vorrichtung nach Anspruch 19,
**dadurch gekennzeichnet,**
**dass** das Gainprofil niederohmige Kontaktstreifen in einem ansonsten hochohmigen Halbleitermaterial aufweist.

21. Verwendung einer Vorrichtung nach einem der Ansprüche 6 bis 20 zur Erzeugung von Laserstrahlung .

## Claims

1. Method for the generation of laser radiation on the basis of semi-conductors by means of stimulated emission in a semi-conductor (1), where a part of the divergent laser light emerging from the semi-conductor (1) is reflected back to the semi-conductor (1) by means of a reflecting element (3), and a part of this reflecting laser light is again injected into the semi-conductor (1) by way of the inlet/outlet opening (6) of the said semi-conductor (1), where the stimulated emission is effected in the semi-conductor (1) by way of an external and unstable resonator,
wherein
the distance d between the semi-conductor (1) and the reflecting element (3) suffices for a plane mirror without usage of further beam-forming elements of the condition 0.1 < d * λ / D² < 10, where D is the width of the inlet/outlet opening (6) of the semi-conductor (1) and λ is the emission wave length and the condition with usage of further beam-forming elements and/or of another reflecting element (3) is computationally adapted by means of conversion of lengths and distances in accordance with the imaging laws of optics.

2. Method according to Claim 1,
wherein
no influence is taken on the divergence of the divergent laser light emerging from the semi-conductor (1) in the plane of the epitaxy.

3. Method according to one of the previous Claims,
wherein
the reflection of a part of the laser light emerging from the semi-conductor (1) is effected by a plane mirror (3) or a curvature mirror.

4. Method according to one of the previous Claims,
wherein
the surface normal of the reflecting element (3) has a finite angle to the surface normal of the light outlet facet of the semi-conductor (1).

5. Method according to one of the previous Claims,
wherein,
by means of a resonator-external aperture, at least one diffraction maximum, with the exception of the central diffraction maximum, is vignetted or masked out.

6. Device for the generation of laser radiation consisting of an external and unstable resonator which has a semi-conductor (1) and a reflecting element (3) arranged outside of the semi-conductor (1),
wherein
the distance d between the semi-conductor (1) and the reflecting element (3) for a plane mirror without usage of further radiation-forming elements is selected in such a way that the condition 0.1 < d * A / D² < 10 suffices, where D is the width of the inlet / outlet opening (6) of the semi-conductor (1) and λ is the emission wave length and the condition with usage of further radiation-forming elements and/or of another reflecting element (3) is computationally adapted by means of the conversion of lengths and distances according to the imaging laws of optics.

7. Device according to Claim 6,
wherein
the width (FHWM) of the feedback light via the external resonator where said width is measured as a full width at half intensity, the width (FHWM) of the inlet/outlet opening (6) exceeds by at least three times the semi-conductor (1).

8. Device according to Claim 6 or 7,
wherein
the semi-conductor laser is an edge-emitting high performance diode laser or a vertical emitter (VCSL).

9. Device according to Claim 8,
wherein
the device additionally has a cylinder lens (2) which is arranged between the reflecting element (3) and the semi-conductor (1) in such a way that it has no influence on the divergence of the laser light in the plane of the epitaxy.

10. Device according to Claims 6 to 9,
wherein
the reflecting element (3) is a plane mirror or a curved mirror.

11. Device according to Claim 10,
wherein
the surface normal of the plane mirror (3) has a finite angle to the surface normal of the light outlet facet of the semi-conductor (1).

12. Device according to Claim 11,
wherein
the angle of the surface normal assumes a value, through which transversal modes of a higher order of the semi-conductor laser are determined.

13. Device according to Claim 12,
wherein
the angle of the surface normal assumes a value, which corresponds to that transversal mode that is preferred by the electrode contacting of the semi-conductor laser.

14. Device according to Claims 10 to 13,
wherein
the inlet / outlet opening (6) of the semi-conductor (1) has an expansion of 100 µm to 1 mm and the distance between semi-conductor (1) and plane mirror (3) is between 3 cm and 10 cm.

15. Device according to Claims 6 to 14,
wherein
the device has an additional aperture.

16. Device according to Claim 15,
wherein
the aperture is an orifice.

17. Device according to Claims 6 to 16,
wherein
the reflecting element (3) is at least a frequency selective element.

18. Device according to Claim 17,
wherein
the frequency selective element is a lattice (7) or an etalon (8).

19. Device according to Claims 6 to 18,
wherein
the semi-conductor (1) has a gain profile and/or a refractive index profile.

20. Device according to Claim 19,
wherein
the gain profile has low-ohm contact stripes in an otherwise high-ohm semi-conductor material.

21. Use of a device according to one of the Claims 6 to 20 for the generation of laser radiation.

## Revendications

1. Procédé de production de rayonnement laser sur la base de semi-conducteurs, au moyen d'émission stimulée dans un semi-conducteur (1), procédé dans lequel une partie de la lumière laser divergente sortant du semi-conducteur (1) est renvoyée vers le semi-conducteur (1) par réflexion au moyen d'un élément réflecteur (3), et dans lequel une partie de cette lumière laser réfléchie est réinjectée dans le semi-conducteur (1) par l'orifice d'entrée/de sortie (6) de ce dernier, l'émission stimulée dans le semi-conducteur (1) étant effectuée au moyen d'un résonateur externe instable,
procédé **caractérisé en ce que** la distance d entre le semi-conducteur (1) et l'élément réflecteur (3), lequel est un miroir plan, satisfait la condition 0.1 < d * λ / D² < 10 si aucun autre élément formant des faisceaux n'est utilisé, D étant la largeur de l'orifice d'entrée/de sortie (6) du semi-conducteur (1), et λ étant la longueur d'onde d'émission, et la condition étant ajustée par calcul, c'est-à-dire : par conversion de longueurs et distances en fonction des lois de projection de l'optique si d'autres éléments formant des faisceaux et/ou bien un élément réflecteur (3) différent sont utilisés.

2. Procédé selon la revendication 1,
**caractérisé en ce que**, sur le plan de l'épitaxie, aucune influence n'est exercée sur la divergence de la lumière laser divergente sortant du semi-conducteur (1).

3. Procédé selon l'une des revendications précédentes,
**caractérisé en ce que** la réflexion d'une partie de la lumière laser sortant du semi-conducteur (1) est effectuée au moyen d'un miroir plan (3) ou d'un miroir courbe.

4. Procédé selon l'une des revendications précédentes,
**caractérisé en ce que** la normale à la surface de l'élément réflecteur (3) présente un angle fini avec la normale à la surface de la facette émettrice de lumière du semi-conducteur (1).

5. Procédé selon l'une des revendications précédentes,
**caractérisé en ce qu'**au moins un maximum de diffraction, sauf le maximum de diffraction central, est vigneté ou diaphragmé, au moyen d'une ouverture externe au résonateur.

6. Dispositif de production de rayonnement laser, constitué d'un résonateur externe instable, lequel présente un semi-conducteur (1) et un élément réflecteur (3) placé en dehors du semi-conducteur (1),
**caractérisé en ce que** la distance d entre le semi-conducteur (1) et l'élément réflecteur (3), lequel est un miroir plan, est choisie de telle façon qu'elle satisfasse la condition 0.1 < d * λ / D² < 10 si aucun autre élément formant des faisceaux n'est utilisé, D étant la largeur de l'orifice d'entrée/de sortie (6) du semi-conducteur (1), et λ, étant la longueur d'onde d'émission, et la condition étant ajustée par calcul, c'est-à-dire : par conversion de longueurs et distances en fonction des lois de projection de l'optique si d'autres éléments formant des faisceaux et/ou bien un élément réflecteur (3) différent sont utilisés.

7. Dispositif selon la revendication 6,
**caractérisé en ce que** la largeur (FHWM) de la lumière couplant rétroactivement au moyen du résonateur externe, mesurée comme la pleine largeur à demi-intensité, dépasse d'au moins trois fois la largeur (FHWM) de l'orifice d'entrée/de sortie (6) du semi-conducteur (1).

8. Dispositif selon la revendication 6 ou 7,
**caractérisé en ce que** le laser à semi-conducteur est un laser à diode forte puissance à émission par la tranche ou un émetteur vertical (VCSL).

9. Dispositif selon la revendication 8,
**caractérisé en ce que** le dispositif intègre en plus une lentille cylindrique (2), placée de telle façon entre l'élément réflecteur (3) et le semi-conducteur (1) qu'elle n'influe pas sur la divergence de la lumière laser sur le plan de l'épitaxie.

10. Dispositif selon les revendications 6 à 9,
**caractérisé en ce que** l'élément réflecteur (3) est un miroir plan ou un miroir courbe.

11. Dispositif selon la revendication 10,
**caractérisé en ce que** la normale à la surface du miroir plan (3) présente un angle fini avec la normale à la surface de la facette émettrice de lumière du semi-conducteur (1).

12. Dispositif selon la revendication 11,
**caractérisé en ce que** l'angle de la normale à la surface atteint une valeur définissant des modes transversaux d'ordre supérieur du laser à semi-conducteur.

13. Dispositif selon la revendication 12,
**caractérisé en ce que** l'angle de la normale à la surface atteint une valeur correspondant à ce mode transversal qui est favorisé par le contact des électrodes du laser à semi-conducteur.

14. Dispositif selon les revendications 10 à 13,
**caractérisé en ce que** l'orifice d'entrée/de sortie (6) du semi-conducteur (1) a une étendue de 100 µm à 1mm, et **en ce que** la distance entre le semi-conducteur (1) et le miroir plan (3) est de 3 cm à 10 cm.

15. Dispositif selon les revendications 6 à 14,
**caractérisé en ce que** le dispositif comporte une ouverture supplémentaire.

16. Dispositif selon la revendication 15,
**caractérisé en ce que** l'ouverture est un diaphragme.

17. Dispositif selon les revendications 6 à 16,
**caractérisé en ce que** l'élément réflecteur (3) est au moins un élément sélectif en fréquence.

18. Dispositif selon la revendication 17,
**caractérisé en ce que** l'élément sélectif en fréquence est un réseau (7) ou un étalon (8).

19. Dispositif selon les revendications 6 à 18,
**caractérisé en ce que** le semi-conducteur (1) a un profil de gain et/ou un profil de l'indice de réfraction.

20. Dispositif selon la revendication 19,
**caractérisé en ce que** le profil de gain présente des bandes de contact de faible valeur ohmique dans un matériau semi-conducteur qui est, pour le reste, de valeur ohmique élevée.

21. Emploi d'un dispositif de production de rayonnement laser selon l'une des revendications 6 à 20.
